Europäisches Patentamt

European Patent Office

Office européen des brevets

(11) Veröffentlichungsnummer: **0 405 200 A1**

## (12) EUROPÄISCHE PATENTANMELDUNG

(21) Anmeldenummer: 90110790.4

(22) Anmeldetag: 07.06.90

(51) Int. Cl.5: **H01L 29/72**, H01L 29/10, H01L 29/36

(30) Priorität: 30.06.89 CH 2440/89

(43) Veröffentlichungstag der Anmeldung:
02.01.91 Patentblatt 91/01

(84) Benannte Vertragsstaaten:
CH DE GB IT LI SE

(71) Anmelder: ASEA BROWN BOVERI AG
Haselstrasse
CH-5401 Baden(CH)

(72) Erfinder: **Bauer, Friedhelm, Dr.**
**Breitenstrasse 9**
**CH-5303 Würenlingen(CH)**
Erfinder: **Stockmeier, Thomas**
**Erbsackerweg 1048**
**CH-5303 Würenlingen(CH)**

(54) MOS-gesteuertes, bipolares Leistungshalbleiter-Bauelement.

(57) Bei einem MOS-gesteuerten, bipolaren Leistungshalbleiter-Bauelement wird, ausgehend von der Struktur eines IGBT, in die Basisschicht zwischen Anode (A) und Kathode (K) eine zur Basisschicht gleichsinnig aber stärker dotierte Rekombinationsschicht (10) eingefügt, welche die Basisschicht in eine obere und untere Basisschicht (7a bzw. 7b) aufteilt.

Die resultierende Struktur bildet eine Serienschaltung aus MOSFET (T) und PIN-Diode (D), die einrastfrei ist und höhere Sperrspannungen ermöglicht.

FIG.2

EP 0 405 200 A1

## TECHNISCHES GEBIET

Die vorliegende Erfindung bezieht sich auf das Gebiet der Leistungselektronik. Sie betrifft insbesondere ein MOS-gesteuertes, bipolares Leistungshalbleiter-Bauelement, umfassend

(a) ein Halbleitersubstrat mit einer Anode und einer Kathode;

(b) in dem Halbleitersubstrat auf der Anodenseite eine Emitterschicht, in der Mitte eine zur Emitterschicht entgegengesetzt dotierte Basisschicht, und auf der Kathodenseite eine Mehrzahl von Kollektorgebieten, welche von der Oberfläche des Halbleitersubstrats her in die Basisschicht hineinragen und gleichsinnig dotiert sind wie die Emitterschicht; und

(c) um die Kollektorgebiete herum vertikale MOS-Transistoren, welche jeweils ein zur Emitterschicht entgegengesetzt dotiertes Sourcegebiet, ein zum Kollektorgebiet gleichsinnig dotiertes Kanalgebiet, die Basisschicht und eine über dem Kanalgebiet angeordnete isolierte Gateelektrode umfassen.

Ein solches Bauelement ist in Form eines IGBT (Insulated Gate Bipolar Transistors) bzw. IGT (Insulated Gate Transistor) z.B. aus dem Artikel von T.P.Chow et al., IEEE Electron Dev. Lett., EDL-6, S.413-415 (1985), bekannt.

## STAND DER TECHNIK

Entsprechend den bisher gebräuchlichen, klassischen Leistungshalbleiter-Bauelementen Transistor und Thyristor existieren heute Konzepte, diese Bauelemente über ein MOS-Gate ansteuerbar zu machen. Diese Konzepte sind der bewährten DMOS-Technik für MOS-Leistungstransistoren entlehnt.

Seit kurzer Zeit sind die ersten IGBTs (Insulated Gate Bipolar Transistors) im Handel erhältlich. Bei diesen Bauelementen liefert ein integrierter MOSFET den notwendigen Basisstrom für einen vertikalen Bipolar-Transistor.

MOS-gesteuerte Thyristoren (MCTs) sind bisher noch nicht zu haben, befinden sich aber bei mehreren Anbietern in intensiver Entwicklung. Für die Herstellung beider Bauelemente wird gewöhnlich auf zuverlässige Prozesse aus der Produktion von Leistungs-MOSFETs zurückgegriffen.

Bei vielen Anwendern findet der IGBT heute bereits grosse Beachtung, weil er sich wegen des MOS-Gates sehr einfach ansteuern lässt und die Eigenschaft der Stromsättigung besitzt. Gerade der Effekt der Stromsättigung verleiht dem IGBT eine besonders grosse elektrische Robustheit und erlaubt damit die Anwendung sehr einfacher Schutztechniken.

Aus den genannten Gründen ist der IGBT nach Einschätzung vieler Anwender attraktiver als etwa der MCT, welcher ja im eingeschalteten Zustand die nicht sättigende Charakte ristik einer Diode besitzt. Es gibt allerdings nach dem derzeitigen Stand der Technik auch (im wesentlichen zwei) Kritikpunkte am IGBT:

(a) mit den derzeit bekannten IGBT-Konfigurationen ist die Ladungsträgermodulation des Sperrspannung tragenden Driftgebietes nur beschränkt möglich. Es ist deshalb schwierig, maximale Sperrspannungen von wesentlich mehr als 1 kV bei zugleich noch akzeptablen ON-Widerständen zu realisieren;

(b) alle bekannten IGBTs besitzen eine parasitäre p-n-p-n-Struktur, welche insbesondere bei hohen Anodenstromdichten einrasten kann. Geschieht dies, so ist das Bauelement nicht mehr über das MOS-Gate steuerbar und kann durch Ueberstrom oder Uebertemperatur zerstört werden. Obwohl dieser unerwünschte Effekt mit diversen Massnahmen bekämpft wird, kann er bis jetzt nicht gänzlich vermieden werden.

## DARSTELLUNG DER ERFINDUNG

Aufgabe der vorliegenden Erfindung ist es nun, ein Leistungshalbleiter-Bauelement zu schaffen, welches mit einer dem IGBT ähnlichen Struktur die Vorteile des IGBT aufweist, aber den unter (b) genannten Nachteil nicht mehr besitzt und bezüglich (a) eine deutliche Verbesserung bringt.

Die Aufgabe wird bei einem Bauelement der eingangs genannten Art dadurch gelöst, dass

(d) innerhalb der Basisschicht zwischen den Kollektorgebieten und der Emitterschicht eine zur Basis schicht gleichsinnig und stark dotierte Rekombinationsschicht angeordnet wird, welche die Basisschicht in eine obere Basisschicht und eine untere Basisschicht unterteilt; und

(e) die Rekombinationsschicht eine Vielzahl von Oeffnungen aufweist, durch welche die obere Basisschicht mit der unteren Basisschicht verbunden ist.

Der Kern der Erfindung besteht darin, ausgehend von einer bekannten IGBT-Struktur in der Basisschicht eine zusätzliche, stark dotierte Rekombinationsschicht in Kathodennähe vorzusehen, wodurch eine Serienschaltung aus MOSFET und PIN-Diode entsteht.

Ein bevorzugtes Ausführungsbeispiel der Erfindung zeichnet sich dadurch aus, dass die obere und untere Basisschicht die gleiche Dotierungskonzentration aufweisen.

Weitere Ausführungsbeispiele der Erfindung ergeben sich aus den Unteransprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1 die Struktur eines IGBT nach dem Stand der Technik;

Fig.2 eine erste Ausführungsform eines Bauelements nach der Erfindung mit durchgehender Rekombinationsschicht sowie das entsprechende Ersatz schaltbild;

Fig.3 eine zweite Ausführungsform eines Bauelements nach der Erfindung mit zusätzlichen Oeffnungen in der Rekombinationsschicht;

Fig.4 eine zu Fig.3 ähnliche Ausführungsform, bei der die Oeffnungen jeweils unterhalb der Kollektorgebiete angeordnet sind; und

Fig.5 die laterale Struktur der Rekombinationsschicht in einem Bauelement gemäss Fig.4.

WEGE ZUR AUSFÜHRUNG DER ERFINDUNG

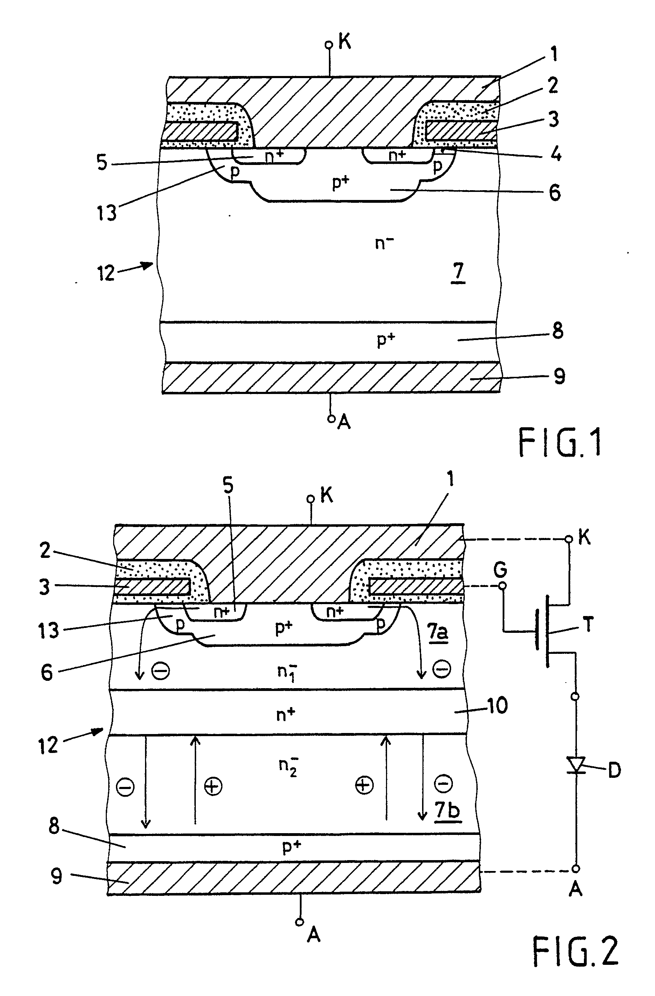

Fig.1 zeigt einen IGBT nach dem derzeitigen Stand der Technik. In einem Halbleitersubstrat 12 (z.B. aus Si) sind zwischen einer Anode A und einer Kathode K eine $p^+$-dotierte Emitterschicht 8, eine $n^-$-dotierte Basisschicht 7 sowie kathodenseitig eine Vielzahl von $p^+$-dotierten Kollektorgebieten 6 angeordnet.

Die Emitterschicht 8 ist durch eine Anodenmetallisierung (z.B. aus Al) kontaktiert, die Kollektorgebiete 6 entsprechend durch eine Kathodenmetallisierung 1. Die Kollektorgebiete 6 sind vollständig von vertikalen MOS-Transistoren umgeben, die aus $n^+$-dotierten Sourcegebieten 5, p-dotierten Kanalgebieten 13, der Basisschicht 7 und isolierten Gateelektroden 3 (z.B. aus Poly-Si) bestehen.

Die Gateelektroden 3 sind über den Kanalgebieten 13 angeordnet und durch eine Gateisolierung 2 (z.B. aus SiO₂) von dem Halbleitersubstrat 12 und der Kathodenmetallisie rung 1 getrennt. Sie erzeugen bei geeigneter Vorspannung in den Kanalgebieten 13 einen Inversionskanal 4.

Die in Fig.2 dargestellte Ausführungsform des neuen, verbesserten Bauelements nach der Erfindung weist innerhalb der $n^-$-dotierten Basisschicht eine weitere, stark n-dotierte Schicht auf, die Rekombinationsschicht 10. Die ursprünglich einheitliche Basisschicht 7 zerfällt damit in eine obere Basisschicht 7a mit der Dotierung $n_1^-$ und eine untere Basisschicht 7b mit der Dotierung $n_2^-$.

Der anodenseitige Teil des neuen Bauelements mit der Rekombinationsschicht 10 der unteren Basisschicht 7b und der Emitterschicht 8 hat die Konfiguration einer aus der Leistungselektronik bekannten PIN-Diode.

Die Kathodenseite des neuen Bauelements enthält eine vertikale DMOS-Struktur, wie sie fast ausschliesslich bei Leistungs-MOSFETs verwendet wird. Das Draingebiet dieses MOSFETs bildet die neu hinzugekommene, stark n-dotierte Rekombinationsschicht 10.

Insgesamt handelt es sich also - wie durch das in Fig.2 eingezeichnete Ersatzschaltbild angedeutet - um eine Serienschaltung aus MOSFET T und PIN-Diode D. Das Gate G der Anordnung wird dabei durch die Gateelektroden 3 gebildet. Obgleich diese Serienschaltung oft auch als Ersatzschaltbild für den herkömmlichen IGBT gemäss Fig.1 verwendet wird, kann sie der physikalischen Natur jenes Bauelements nicht ganz gerecht werden.

Die Funktion der Rekombinationsschicht 10 ist die folgende: Wie bereits erwähnt, ist die Rekombinationsschicht 10 zugleich Elektronenemitter für die PIN-Diode D und Drain für den MOSFET T. Wird diese Schicht als für Löcher nicht transparenter Emitter ausgeführt, so rekombinieren dort alle von der Emitterschicht 8 injizierten Löcher.

Die Löcher werden also im Gegensatz zum herkömmlichen IGBT von den Source- und Kanalgebieten 5 bzw. 13 des MOSFET ferngehalten. Genau damit ist aber die Ursache für das Einrasten ("latch up") des IGBT eliminiert: da die Löcher nicht mehr von den Kollektorgebieten 6 eingesammelt werden - sie rekombinieren ja beim neuen Bauelement bereits in der Rekombinationsschicht 10 - , kann auch kein Potentialabfall über den schwächer p-dotierten Kanalgebieten 13 unterhalb der Sourcegebiete 5 entstehen.

Nach dem allgemeinen Wissensstand polt aber genau eine solche Potentialdifferenz Bereiche des Uebergangs zwischen Kollektorgebiet 6 und Basisschicht 7 in Vorwärtsrichtung und leitet so das Einrasten der parasitären p-n-p-n-Struktur ein.

Da bei dem neuen Bauelement das parasitäre Einrasten aus den oben genannten Gründen unterbunden ist, kann der MOS-Teil kompromisslos auf hohe Stromtragfähigkeit ausgelegt werden (mit kurzen Kanälen, kleinen Elementarzellen und hohen Packungsdichten). Beim herkömmlichen IGBT würden derartige Massnahmen dagegen zu einer wesentlichen Verringerung der Einraststromstärken führen (siehe dazu den eingangs genannten Artikel von T.P.Chow et al.).

Im neuen Bauelement sollte die obere Basisschicht 7a vorzugsweise eine Dicke von wenigen μm besitzen. In diesem Fall kann der Widerstand des MOS-Teils, wie bei Leistungs-MOSFETs für kleine Sperrspannungen üblich, sehr klein gehalten werden und ist gegenüber dem Widerstand der PIN-Diode D zu vernachlässigen.

Darüberhinaus sollte die Dotierung der oberen Basisschicht 7a mit der Dotierung der unteren Basisschicht 7b (dem Driftgebiet der PIN-Diode D) identisch sein, um hohe Durchbruchspannungen zu erreichen.

Durch den Einbau der Rekombinationsschicht wird weiterhin eine gegenüber dem IGBT verbesserte Stromdichtehomogenität erreicht. Es ist daher möglich, bei Benutzung des gleichen Si-Substrats mit dem neuen Bauelement geringere Durchlasswiderstände zu realisieren als mit einem herkömmlichen IGBT.

Bei Bauelementen vom Typ des IGBT ist die Fähigkeit des Vorwärtssperrens unerlässlich. Mit der Struktur gemäss Fig.2 kann aber nur die obere Basisschicht 7a Sperrspannung aufnehmen. Die zusätzlich eingebrachte Rekombinationsschicht 10 blockiert eine Ausbreitung der Raumladungszone in die untere Basisschicht 7b. Da aber die obere Basisschicht 7a nur eine geringe Dicke (wenige $\mu$m) aufweist, hat das Bauelement auch nur eine der Dotierung und Dicke dieser Schicht entsprechende geringe Sperrspannung.

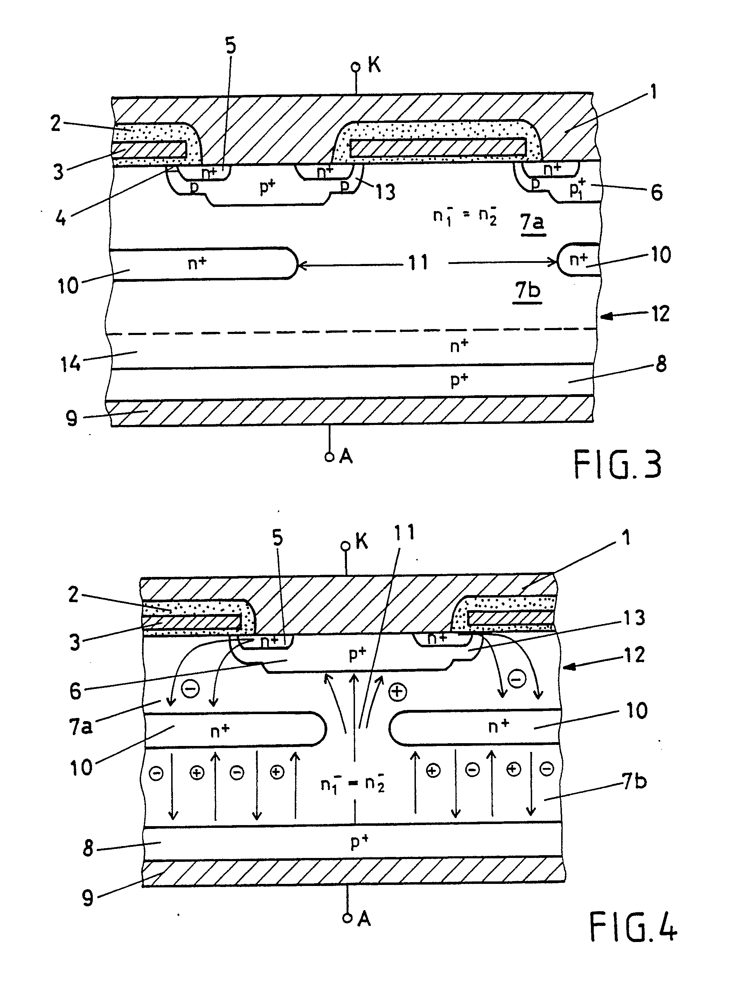

Es ist daher notwendig, wie in Fig.3 dargestellt, in der Rekombinationsschicht 10 Oeffnungen 11 vorzusehen, sodass die obere und untere Basisschicht 7a bzw. 7b miteinander verbunden sind. Beim Aufbau der Sperrspannung kann das Feld nun durch die Rekombinationsschicht 10 hindurchgreifen und sich in den weiten Raum der unteren Basisschicht 7b ausbreiten. Damit ist sichergestellt, dass das neue Bauelement in der Sperrspannung nicht mehr begrenzt ist.

Zusätzlich kann noch zwischen der unteren Basisschicht 7b und der Emitterschicht 8 eine (in Fig.3 gestrichelt eingezeichnete) $n^+$-dotierte n-Stoppschicht 14 vorgesehen werden, wie sie an sich aus dem Stand der Technik bekannt ist.

Für die Anordnung der mit den Oeffnungen 11 versehenen Rekombinationsschicht 10 müssen mehrere Gesichtspunkte berücksichtigt werden: die einzelnen Bereiche der Rekombinationsschicht 10 sollten nicht zu grosse laterale Abmessungen besitzen, damit sich über diese Distanzen keine nennenswerten Potentialdifferenzen aufbauen können.

Für einen weiteren Gesichtspunkt sei noch einmal der parasitäre Einrastprozess beim IGBT herangezogen: ein Teil der von der Anode A (der Emitterschicht 8) kommenden Löcher gelangt nicht direkt in die Kollektorgebiete 6, sondern folgt angenähert den Bahnen der Elektronen (dies ist infolge der Ladungsträgermodulation ein Weg besonders geringen elektrischen Widerstandes). Diese Löcher dringen über die Kanalgebiete 13 in die Kollektorgebiete 6 ein und können in den Kanalgebieten 13 wegen der für die Realisierung einer Inversionsschicht notwendigen geringen Dotierung einen Spannungsabfall erzeugen, welcher zu einer Durchlasspolung der entsprechenden Diode führt.

Es ist daher vorteilhaft, die Bereiche der Rekombinationsschicht 10 möglichst unterhalb der Inversionskanäle 4, den Gateelektroden 3 und den Kanalgebieten 13 zu plazieren (Fig.4) und damit die Löcher durch "Zwangsrekombination" am Eindringen in die kritischen Bereiche des Bauelementes zu hindern (in Fig.4 sind die Löcher- und Elektronenströme schematisch durch Pfeile mit Plus- und Minuszeichen dargestellt). Entsprechend sollten die Oeffnungen 11 genau unterhalb der Kollektorgebiete 6 angeordnet sein. Damit stehen den Löchern die konventionellen, auch vom IGBT her bekannten Wege zur Kathode K zur Verfügung.

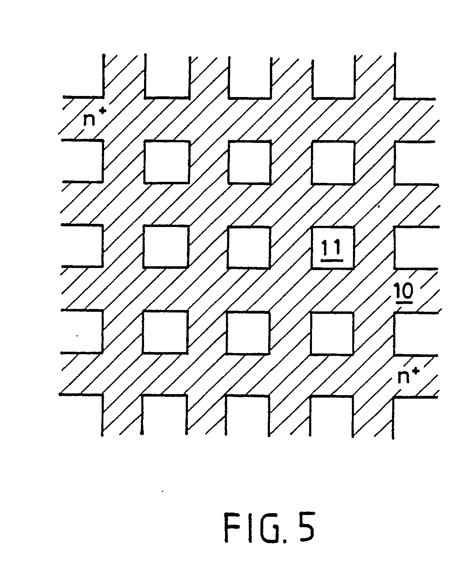

Im Falle einer aus quadratischen oder rechteckigen Zellen bestehenden Bauelementstruktur hat die Rekombinationsschicht 10 (bei Draufsicht auf den Wafer) entsprechend die Form eines Gitternetzes mit quadratischen oder rechteckigen Oeffnungen 11 (Fig.5). Im Uebrigen kann die Form der durchbrochenen Rekombinationsschicht 10 allen derzeit vom IGBT her bekannten Zellenstrukturen problemlos angepasst werden.

Zur Herstellungstechnologie für ein Bauelement nach der Erfindung seien noch folgende Anmerkungen gemacht: Die hier vorgeschlagenen Rekombinationsschichten 10 sind mit den aus der Bipolartechnik bekannten vergrabenen Kollektoren vergleichbar. Für die Herstellung der beschriebenen MOS-gesteuerten PIN-Diode kann daher auf herkömmliche Techniken der Silizium-Epitaxie zurückgegriffen werden.

Ein möglicher Prozess besteht darin, nach der Erzeugung der Emitterschicht 8 die $n^+$-Dotierung für das Gitternetz der Rekombinationsschicht 10 durch eine Maske entsprechender Struktur vorzunehmen. Hierfür ist eine Ionenimplantation von z.B. Arsen besonders geeignet.

Es folgt ein Epitaxieschritt, bei welchem die obere Basisschicht 7a mit einer Dicke von wenigen $\mu$m erzeugt wird. Im Anschluss an diesen Teilprozess kann der MOS-Steuerkopf mit den bekannten Prozessschritten hergestellt werden.

Zum Schluss sei noch darauf hingewiesen, dass selbstverständlich das Bauelement nach der Erfindung auch in einer komplementären Anordnung ausgeführt werden kann. Dieses komplementäre Bauelement zeichnet sich dadurch aus, dass die Basisschichten 7, 7a, 7b $p^-$-dotiert, die Kollektorgebiete 6 und die Emitterschicht 8 $n^+$-dotiert, die Kanalgebiete 13 n-dotiert und die Sourcegebiete 5 und die Rekombinationsschicht 10 $p^+$-dotiert sind.

Wird bei diesem Bauelement eine zusätzliche Stoppschicht zwischen unterer Basisschicht 7b und Emitterschicht 8 vorgesehen, so ist dies eine $p^+$-dotierte p-Stoppschicht, die in gleicher Weise angeordnet wird, wie die komplementäre n-Stoppschicht 14 in Fig.3.

**Ansprüche**

MOS-gesteuertes, bipolares Leistungshalbleiter-Bauelement, umfassend

(a) ein Halbleitersubstrat (12) mit einer Anode (A) und einer Kathode (K);

(b) in dem Halbleitersubstrat (12) auf der Anodenseite eine Emitterschicht (8), in der Mitte eine zur Emitterschicht (8) entgegengesetzt dotierte Basisschicht (7), und auf der Kathodenseite eine Mehrzahl von Kollektorgebieten (6), welche von der Oberfläche des Halbleitersubstrats (12) her in die Basisschicht (7) hineinragen und gleichsinnig dotiert sind wie die Emitterschicht (8); und

(c) um die Kollektorgebiete (6) herum vertikale MOS-Transistoren, welche jeweils ein zur Emitterschicht (8) entgegengesetzt dotiertes Sourcegebiet (5), ein zum Kollektorgebiet (6) gleichsinnig dotiertes Kanalgebiet (13), die Basisschicht (7) und eine über dem Kanalgebiet (13) angeordnete isolierte Gateelektrode (3) umfassen;

dadurch gekennzeichnet, dass

(d) innerhalb der Basisschicht (7) zwischen den Kollektorgebieten (6) und der Emitterschicht (8) eine zur Basisschicht (7) gleichsinnig und stark dotierte Rekombinationsschicht (10) angeordnet wird, welche die Basisschicht (7) in eine obere Basisschicht (7a) und eine untere Basisschicht (7b) unterteilt; und

(e) die Rekombinationsschicht (10) eine Vielzahl von Oeffnungen (11) aufweist, durch welche die obere Basisschicht (7a) mit der unteren Basisschicht (7b) verbunden ist.

2. Bauelement nach Anspruch 1, dadurch gekennzeichnet, dass die obere Basisschicht (7a) nur wenige $\mu$m dick ist.

3. Bauelement nach Anspruch 2, dadurch gekennzeichnet, dass die obere und untere Basisschicht (7a bzw. 7b) die gleiche Dotierungskonzentration aufweisen.

4. Bauelement nach Anspruch 1, dadurch gekennzeichnet, dass die Oeffnungen (11) jeweils unterhalb der Kollektorgebiete (6) angeordnet sind.

5. Bauelement nach Anspruch 4, daurch gekennzeichnet, dass die Oeffnungen (11) rechteckig oder quadratisch sind und die Rekombinationsschicht (10) die Form eines Gitternetzes hat.

6. Bauelement nach einem der Ansprüche 1 bis 5, dadurch gekennzeichnet, dass die Basisschichten (7, 7a, 7b) $n^-$-dotiert, die Kollektorgebiete (6) und die Emitterschicht (8) $p^+$-dotiert, die Kanalgebiete (13) p-dotiert und die Sourcegebiete (5) und die Rekombinationsschicht (10) $n^+$-dotiert sind.

7. Bauelement nach Anspruch 6, dadurch gekennzeichnet, dass zwischen der unteren Basisschicht (7b) und der Emitterschicht (8) eine $n^+$-dotierte n-Stoppschicht (14) angeordnet ist.

8. Bauelement nach einem der Ansprüche 1 bis 5, dadurch gekennzeichnet, dass die Basisschichten (7, 7a, 7b) $p^-$-dotiert, die Kollektorgebiete (6) und die Emitterschicht (8) $n^+$-dotiert, die Kanalgebiete (13) n-dotiert und die Sourcegebiete (5) und die Rekombinationsschicht (10) $p^+$-dotiert sind.

9. Bauelement nach Anspruch 8, dadurch gekennzeichnet, dass zwischen der unteren Basisschicht (7b) und der Emitterschicht (8) eine $p^+$-dotierte p-Stoppschicht angeordnet ist.

FIG.1

FIG.2

**FIG.3**

**FIG.4**

FIG. 5

# EUROPÄISCHER RECHERCHENBERICHT

**Europäisches Patentamt**

Nummer der Anmeldung

EP 90 11 0790

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 738 670 (NISSAN MOTOR CO., LTD) <br> * Das ganze Dokument * <br> ----- | 1,2;6,8 | H 01 L 29/72 <br> H 01 L 29/10 <br> H 01 L 29/36 |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| DEN HAAG | 20-08-1990 | MORVAN D.L.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)